# DEMANDE DE BREVET EUROPEEN

(11) **EP 0 551 240 A1**
(43) Date de publication de la demande: **14.07.1993**
(21) Numéro de dépôt: 93440002.9
(22) Date de dépôt: 11.01.1993
(51) Int. Cl.: F24C 7/08, H05B 3/74, H03K 17/94

(54) **Procédé de commande à l'aide d'un détecteur optique d'un foyer d'une table de cuisson en vitrocéramique.**

(30) Priorité: 09.01.1992 FR 9200273
(71) Demandeur: COMPAGNIE EUROPEENNE POUR L'EQUIPEMENT MENAGER "CEPEM", F-45140 St Jean-de-la-Ruelle (FR)
(72) Inventeur: Darigny, Franck, F-67200 Mittelhausbergen (FR)
(74) Mandataire: Benoit, Monique

(57) **Abrégé**

Procédé de commande d'une table vitrocéramique à partir d'un détecteur optique (3), caractérisé en ce que l'on mesure périodiquement et successivement une première valeur dite "REFLET", émetteur (1) activé, et une deuxième valeur dite "AMBIANCE", émetteur (1) désactivé, que l'on effectue la différence D = "REFLET" - "AMBIANCE", que l'on utilise cette différence pour déterminer le seuil de détection à partir de données correspondant aux valeurs de référence et des données évolutives correspondant aux valeurs antérieures acquises lors du ou des fonctionnement(s) précédent(s).

Cette invention intéresse les fabricants de claviers ou de détecteurs optiques.

## Description

La présente invention se rapporte à un procédé de détection et de commande à touche optique pour un appareil électrique à paroi transparente.

La touche optique fonctionne en détecteur de présence et trouve une application notablement intéressante dans le domaine de la commande d'un des foyers d'une table de cuisson dite vitrocéramique.

Le détecteur à touche optique selon l'invention est placé sous une paroi transparente et n'est pratiquement pas influencé par le degré de luminosité environnante.

On connaît déjà plusieurs moyens de détection de présence utilisant le principe de la réflexion optique.

Il s'agit, par exemple, de la détection de la fin de bande ou de la fin de papier sur une imprimante. Il existe entre le fond, derrière le papier et la surface du papier, une différence optique suffisante pour réaliser facilement une détection optique de présence par réflexion. Par ailleurs, le volume intérieur est protégé de la lumière extérieure par un capot opaque.

L'ensemble de ces moyens permet d'arriver à une détection systématique dans les meilleures conditions.

De nombreux détecteurs optiques fonctionnent de façon simple par la modification d'éclairement d'un détecteur lumineux dans une cellule fermée au droit d'une fenêtre d'entrée constituant la zone sensible de la touche de commande.

Le faisceau direct ou réfléchi émis est interrompu par un corps à détecter ou servant à une commande.

La présente invention a pour but de permettre une détection efficace systématique à l'aide d'un détecteur à touche optique fonctionnant par réflexion derrière une plaque transparente, quelles que soient les conditions d'éclairage ambiant, même les plus défavorables, c'est-à-dire celles correspondant à une ambiance lumineuse perturbée ou sous une vitre à transparence réduite par des dépôts de toute sorte de matières non opaques, notamment grasses.

Ainsi, peu importe le niveau d'éclairement ambiant ou la perturbation de celui-ci. Peu importe également, mais jusqu'à un certain degré, l'état de propreté de la zone de détection optique matérialisant la touche.

Il faut ajouter à ces avantages ceux propres à la détection lumineuse, c'est à dire l'indépendance totale par rapport à tous les parasites d'autre nature que lumineux.

Le procédé selon l'invention se caractérise en ce que l'on effectue un nombre prédéterminé de cycles élémentaires de détection successifs comprenant chacun une première phase d'acquisition pendant laquelle on prélève, émetteur activé, un premier échantillon correspondant à une première valeur dite "REFLET" et une deuxième phase d'acquisition pendant laquelle on prélève, émetteur désactivé, un deuxième échantillon correspondant à une deuxième valeur dite "AMBIANCE", et en ce que, pour chaque cycle, on calcule la différence :

D = "REFLET " - "AMBIANCE ".

On caractérise cette différence en fonction de sa valeur pour la faire correspondre à un état, soit inférieur dit "REPOS" correspondant à une touche non activée, soit supérieur dit "PIC" correspondant à une touche activée.

Après filtrage et pondération, on mémorise une valeur représentative de la différence D après le nombre prédéterminé de cycles élémentaires de détection.

On détermine à chaque fois un nouveau seuil de détection fonction des caractéristiques momentanées du détecteur optique et des conditions optiques et d'éclairage du moment. On compare la valeur momentanée de la différence D au nouveau seuil de détection et on valide ou non la détection.

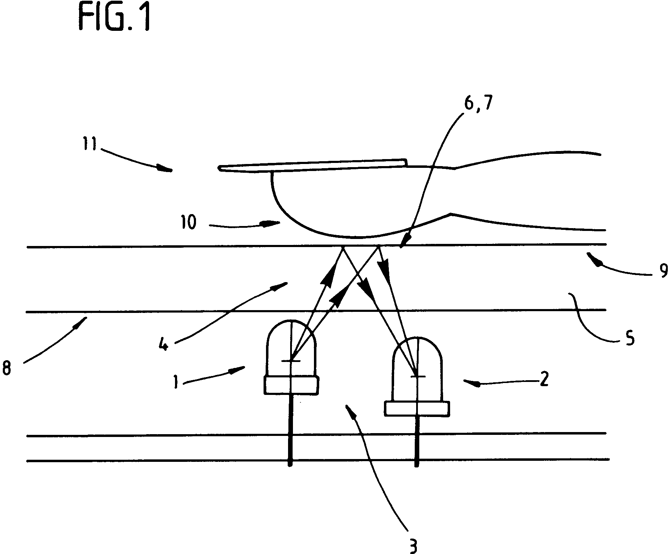

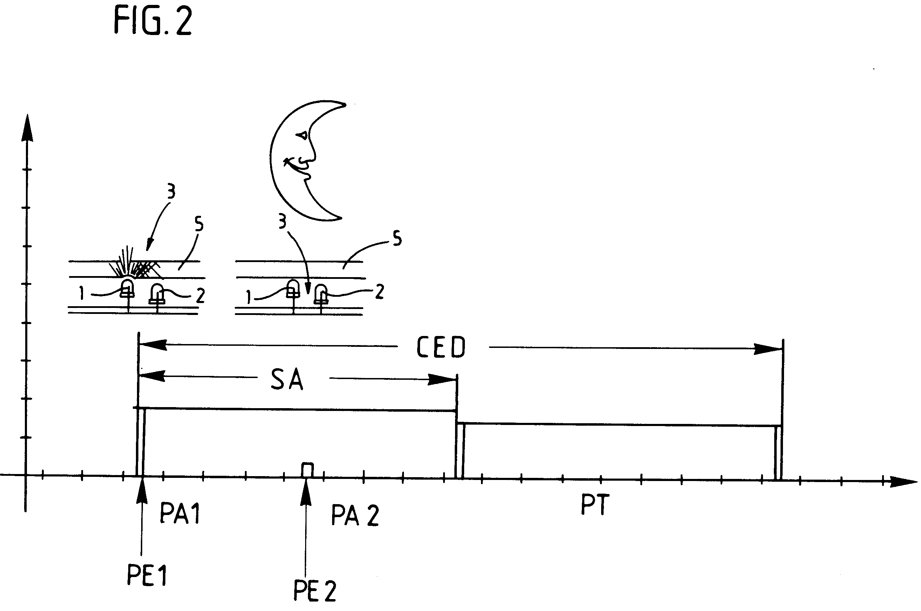

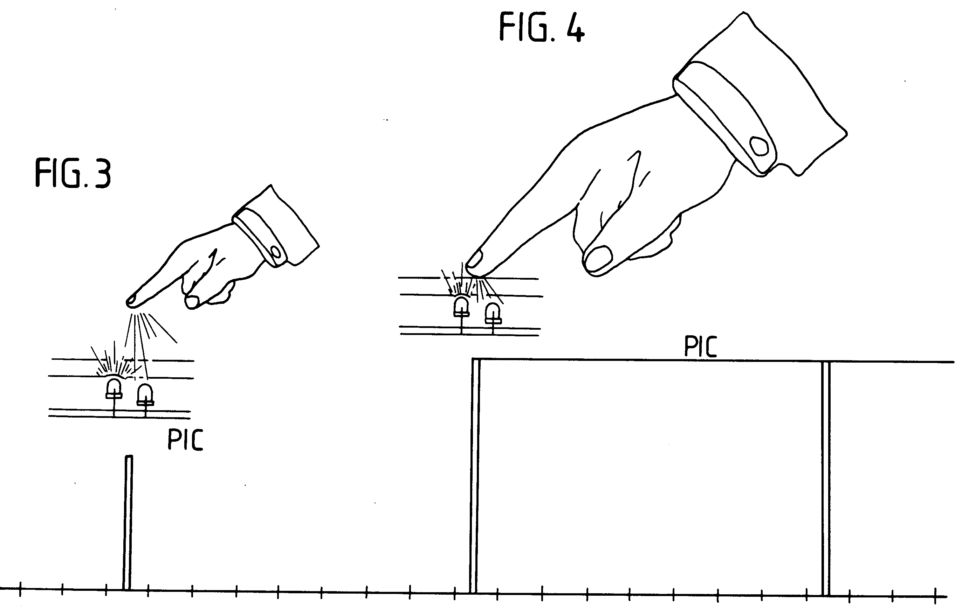

D'autres caractéristiques techniques et avantages de l'invention apparaîtront dans la description qui suit, donnée à titre d'exemple et accompagnée des dessins qui représentent :
. la figure 1 : une vue schématique en coupe montrant le couple émetteur-récepteur devant la zone sensible du détecteur à touche optique selon l'invention avec représentation du doigt d'activation ;
. la figure 2 : la représentation schématique du détecteur dans les deux états correspondant aux deux échantillonnages, et le graphique correspondant illustrant la séquence d'acquisition puis de mesure dans le cas d'une ambiance sombre ou de nuit ;
. les figures 3 et 4 : des représentations schématiques montrant deux valeurs du niveau haut de la valeur PIC pour deux positions du doigt d'activation, respectivement en approche et en contact avec la surface sensible du détecteur en ambiance sombre ou de nuit.

Le détecteur optique selon l'invention est formé d'un émetteur 1 d'un rayonnement lumineux visible ou invisible, par exemple infrarouge, et d'un récepteur 2 sensible à ce rayonnement lumineux formant un couple 3 émetteur-récepteur, disposés à proximité l'un de l'autre sous une étendue 4 d'une plaque 5 d'un matériau tel que verre, vitrocéramique ou autre, transparent au rayonnement lumineux visible ou invisible utilisé.

L'étendue 4 située au droit du couple émetteur-récepteur 3 est une zone sensible d'activation ou fenêtre de détection 6 d'une touche optique désignée généralement par 7.

L'émetteur 1 et le récepteur 2 sont placés l'un à côté de l'autre en face de la zone sensible ou fenêtre de détection 6 de la touche optique, dans une position et à une distance adaptées pour présenter le meilleur rendement de détection possible en fonction de leur angle d'ouverture d'émission ou de réception.

Le récepteur 2 reçoit le faisceau lumineux réfléchi par les deux surfaces inférieure 8 et supérieure 9 de verre ou de vitrocéramique de la plaque 5, mais surtout par la surface supérieure la plus éloignée de la plaque 5, c'est-à-dire celle dont le dos constitue la zone sensible de détection. La réflexion augmente lors de la commande en raison de la présence d'une forme quelconque en contact avec ou à proximité de la zone sensible du détecteur.

Cette forme, dans le cadre de l'utilisation, est constituée normalement par la sous-face 10 de l'extrémité d'un doigt 11 arrivant à faible distance de ou en contact avec la zone sensible 6.

Elle représente une perturbation optique extérieure de réflexion augmentant suffisamment la réflexion, c'est-à-dire le nombre de rayons réfléchis, pour engendrer une détection systématique après les phases d'acquisition puis de traitement du signal de détection correspondant au mode d'exploitation décrit ci-après.

Le mode d'exploitation utilisé dans cette invention est basé sur le procédé suivant, permettant de s'affranchir totalement des perturbations extérieures habituelles.

Il est basé sur la création d'un seuil variable de détection auto-ajustable qui tient compte à tout moment des valeurs des états extrêmes ou antérieurs : dans le cas d'une touche non activée, valeur dite de "REPOS" (état inférieur) et dans le cas d'une touche activée, valeur dite de "PIC" (état supérieur).

Ces valeurs extrêmes ou antérieures prises en compte pour la détermination du seuil de détection sont d'une part celles de référence stockées dans une première mémoire dite mémoire de référence mais aussi des données obtenues à partir des valeurs antérieures de fonctionnement et stockées dans une mémoire d'ajustement.

La détermination du seuil s'effectue à partir des valeurs mesurées stockées dans une mémoire de travail et en fonction des données existant dans les mémoires de référence et d'ajustement.

Une détection élémentaire s'effectue périodiquement par cycles élémentaires de détection CED répétés. Chaque cycle comprend une séquence d'acquisition SA décomposée en deux phases d'acquisition PA1 et PA2 puis une phase de traitement PT sur une période d'une durée élémentaire faible, durée de l'ordre du temps d'actionnement répété d'une touche mécanique.

La prise en compte s'effectue après un nombre prédéterminé de cycles élémentaires de détection CED, par exemple égal à quatre.

Un cycle élémentaire de détection se décompose en deux phases d'acquisition et en une phase de traitement.

### A. PHASES D'ACQUISITION : PA1 et PA2

**1. L'émetteur est activé :** **PA1**
   En raison de la disposition et des caractéristiques du couple émetteur-récepteur 3, les rayonnements incidents reçus par le récepteur 2 proviennent aussi bien des rayonnements de l'émetteur 1 réfléchis sur la vitre que du rayonnement provenant de sources extérieures arrivant au récepteur 2.
   Un premier échantillon PE1 de la valeur du signal est prélevé aux bornes du montage électronique d'acquisition et mis en mémoire pour traitement ultérieur.
   Encore inexploitable, cette valeur peut tout aussi bien être le résultat d'une réflexion de l'émetteur à laquelle s'ajoute le rayonnement direct en provenance d'une source extérieure parasite incontrôlable (par exemple le soleil, une lampe d'éclairage domestique.)
   On appelle cette première valeur "REFLET".
**2. L'émetteur est désactivé : PA2**
   Un second échantillon PE2 de la valeur du signal de détection est prélevé aux bornes du montage électronique d'acquisition. Il constitue une bonne image instantanée de l'environnement lumineux dans lequel le couple émetteur-récepteur est plongé.
   On appelle cette seconde valeur "AMBIANCE".
   Elle est caractérisée par son niveau, à savoir :
   - faible ou nul = "AMBIANCE" dite "de nuit" ;
   - moyen ou saturé = "AMBIANCE" dite "de jour".

### B. PHASE DE TRAITEMENT : PT

En vue de l'assimilation d'une touche à la détection, et ceci quelles que soient les conditions d'ambiances lumineuses dans lesquelles le système est plongé, la première partie de la phase de traitement consistera à effectuer la différence :
D = "REFLET" - "AMBIANCE"
entre les deux valeurs des échantillons PE1 et PE2 pour isoler la partie utile du signal, qui caractérisé la pure réflexion du rayonnement en provenance de l'émetteur.
Deux états distincts du système peuvent alors caractériser cette partie utile du signal correspondant à :
. un état inférieur caractérisé par une valeur appelée "REPOS" donnée par une touche non activée ;
. un état supérieur caractérisé par une valeur appelée "PIC" donnée par une touche activée.

Il existe de multiples valeurs "REPOS" et "PIC".
Diverses valeurs importantes ou remarquables sont mémorisées.
Il s'agit des valeurs initiales extrêmes traduisant les caractéristiques mécaniques et physiques du système. Ces valeurs ou les données correspondant à ces valeurs sont stockées lors de la première mise en fonction dans la mémoire de référence et consultées lors de la phase de traitement.
Il s'agit aussi des valeurs antérieures ou des données évolutives correspondant à ces valeurs agissant en tant que valeurs dites d'apprentissage qui sont stockées en permanence dans une mémoire d'ajustement consultée lors de la phase de traitement.
Après pondération et filtrage au cours de la deuxième partie de la phase de traitement, on validera une touche activée si l'augmentation de la différence D est supérieure à un seuil adapté de détection calculé à partir des valeurs de "REPOS" et de "PIC" relevées selon un algorithme particulier en tenant compte des valeurs antérieures et des valeurs de référence.
L'environnement dans lequel le système est placé peut évoluer et se modifier : chauffage des récepteurs, salissures sur la plaque modifiant les caractéristiques de réfraction et suite à des modifications liées à l'opérateur, doigts mouillés ou sales. Ces modifications entraînent des variations non négligeables des valeurs de "REPOS" et de "PIC".
Pour se placer toujours dans les meilleurs conditions de détection, deux séries d'adaptations sont prévues :
- **adaptation rapide** qui mémorise dans une mémoire de travail les variations des valeurs de "REPOS" et de "PIC", par exemple une valeur toutes les secondes ;
- **adaptation lente** qui, à partir des valeurs résultant de la première adaptation, les fait évoluer quotidiennement dans une mémoire d'ajustement.

Les données correspondant aux valeurs résultant de ces deux adaptations ainsi que celles mémorisées lors de l'initialisation entrent dans le calcul des valeurs limites de dérive du système.

Ainsi, pendant plusieurs cycles élémentaires de détection CED, on caractérisé la valeur de "PIC" assimilable à une touche activée et indépendante de l'ambiance lumineuse dans laquelle elle est plongée.

Plus précisément, selon le procédé utilisé, on met en mémoire, après un nombre prédéterminé de cycles élémentaires de détection CED, une variable rendant compte de la valeur de la différence D existant entre les séries de deux échantillons prélevés PE1 et PE2 en vue de la détermination d'un nouveau seuil de détection correspondant aux conditions optiques et d'éclairage du moment.

Selon l'exemple choisi, le nombre de cycles élémentaires avant chaque détection élémentaire correspondant à une séquence d'acquisition est égal à quatre.

On décrira maintenant le principe général de la prise en compte d'une touche dans les cas extrêmes d'une ambiance de nuit et d'une ambiance de jour.

### A. Ambiance de nuit.

La valeur initiale de la différence mesurée n'est constituée pratiquement que de la réflexion de l'émetteur sur la vitre. L'ambiance parasite est nulle ou faible (figure 2).
" REPOS " = " REFLET " - "AMBIANCE de nuit ".
Un doigt se présente, la réflexion augmente jusqu'à venir se stabiliser à la valeur dite "PIC" lorsque celui-ci se pose sur la surface extérieure de la vitre ou de la plaque de vitrocéramique.
La prise en compte s'effectue après un nombre prédéterminé de cycles pour éviter l'incidence d'un événement furtif.
La valeur "PIC" constitue la donnée utilisée pour la détermination du seuil de détection pour chaque cas.
Celle-ci étant variable selon les conditions de réflexion et les particularités de forme (doigt) activant la touche, on réalise ainsi un véritable auto-ajustement du seuil de détection.

### B. Ambiance de jour.

Elle est caractérisée par un éclairage d'intensité notable extérieur au détecteur, par exemple une lampe à filament alimentée sous la tension du secteur à 50 Hz.
Dans cette ambiance lumineuse perturbée de façon non négligeable, la valeur de la différence donnée par : "REPOS" = "REFLET" - "AMBIANCE de jour" reste semblable à celle initialement connue en ambiance de nuit.
Une tentative d'activation de la touche donne lieu au même état final de prise en compte du rayonnement réfléchi en provenance de l'émetteur.
En effet, le doigt qui se présente au-dessus de la zone sensible forme une ombre qui atténue la puissance lumineuse directe de la source lumineuse parasite extérieure.

La figure 2 a pour but d'illustrer le procédé d'établissement du seuil de détection.

Les figures 3 et 4 montrent deux valeurs "PIC", respectivement pour une position d'approche et de contact du doigt d'activation.

On expliquera ci-après le fonctionnement général permanent.

Dès que le montage électronique d'exploitation est alimenté, les phases d'acquisition et de traitement se déroulent automatiquement en vue de déterminer un seuil de détection adapté à l'ambiance.

En l'absence de commande, ce seuil est celui dit de "REPOS" correspondant à l'état inférieur de la différence :
D = "REFLET" - "AMBIANCE"

Lors d'une variation lumineuse extérieure, ce seuil se modifiera automatiquement lors de la séquence d'acquisition et de traitement suivant immédiatement le début de cette variation.

Il s'auto-ajustera à chaque modification des conditions optiques et d'éclairage du milieu environnant.

Ceci s'applique également à la modification engendrée par l'activation d'une touche par un doigt.

L'approche du doigt modifiera le degré de luminosité extérieure et introduira, dans le champ de détection, une surface de réflexion.

La vitesse d'approche du doigt n'étant normalement pas élevée par rapport à la périodicité du cycle de détection, il se déroulera plusieurs cycles élémentaires de détection pendant son approche.

Une détection pourra, dans certains cas, avoir déjà eu lieu pour une position rapprochée, mais non de contact, du doigt d'activation de la touche.

Les figures 3 et 4 ont pour but de montrer la hauteur du niveau "PIC" respectivement pour une position rapprochée et une position de contact du doigt d'activation de la touche.

Il peut donc se produire une détection avant la position de contact si le niveau "PIC" dépasse déjà le seuil de détection correspondant aux conditions lumineuses du moment.

On a ainsi créé, pour une table de cuisson à plaque vitrocéramique, un détecteur à commande par touche optique présentant un seuil auto-ajustable à chaque modification du degré de luminosité environnante ou des conditions optiques du milieu environnant.

## Revendications

1. Procédé de détection optique et de commande de fonctionnement d'une table de cuisson à plaque de cuisson transparente, notamment du type vitrocéramique, à l'aide d'un couplé émetteur-récepteur situé sous la plaque et par l'approche du doigt de l'utilisateur, caractérisé en ce que l'on effectue un nombre prédéterminé de cycles élémentaires de détection CED successifs comprenant chacun une première phase d'acquisition PAI pendant laquelle on prélève, émetteur activé, un premier échantillon PE1 correspondant à une première valeur dite "REFLET" et une deuxième phase d'acquisition PA2 pendant laquelle on prélève, émetteur désactivé, un deuxième échantillon PE2 correspondant à une deuxième valeur dite ""AMBIANCE", en ce que pour chaque cycle on calcule la différence D = "REFLET" - "AMBIANCE", on particularise cette différence en fonction de sa valeur pour la faire correspondre à un état, soit inférieur dit "REPOS" correspondant à une touche non activée, soit supérieur dit "PIC" correspondant à une touche activée, et en ce qu'après filtrage et pondération, on mémorise une valeur représentative de la différence D, après le nombre prédéterminé de cycles élémentaires de détection, on détermine à chaque fois un nouveau seuil de détection fonction des conditions optiques et d'éclairage du moment et d'autres paramètres à partir des données correspondant aux valeurs de référence "REPOS" et "PIC" mises dans une mémoire de référence et des données évolutives correspondant aux valeurs "REPOS" et "PIC" antérieures stockées dans une mémoire d'ajustement, on compare la valeur momentanée de la différence D au nouveau seuil de détection et on valide ou non la détection.

2. Procédé selon la revendication 1, caractérisé en ce que l'on stocke dans une mémoire de référence des données obtenues à partir des valeurs extrêmes de référence, les valeurs "REPOS" et "PIC" lors de la première mise en service de l'appareil en vue de les utiliser lors de la détermination du seuil de détection.

3. Procédé selon les revendications 1 et 2, caractérisé en ce que l'on stocke dans une mémoire d'ajustement des données obtenues à partir des valeurs "REPOS" et "PIC" résultant des mesures précédentes en vue de les utiliser lors de la détermination du seuil de détection.

4. Procédé selon l'une quelconque des revendications précédentes, caractérisé en ce que l'on réalise une adaptation rapide en mémorisant périodiquement les variations des valeurs de "REPOS" et de "PIC" et en ce que l'on réalise une adaptation lente à partir des valeurs de l'adaptation rapide, adaptation qui les fait évoluer quotidiennement dans la mémoire d'ajustement.

5. Procédé selon l'une quelconque des revendications précédentes, caractérisé en ce que le nombre prédéterminé de cycles élémentaires de détection CED avant mise en mémoire est égal à quatre.

6. Détecteur optique sensible à un rayonnement lumineux, notamment infrarouge, de commande pour un des foyers d'une table de cuisson à plaque transparente, notamment en matériau du type vitrocéramique, servant de support de cuisson, caractérisé en ce qu'il est formé d'un émetteur (1) d'un rayonnement lumineux visible ou invisible, d'un récepteur (2) sensible à ce rayonnement lumineux formant un couple (3) émetteur-récepteur, disposés à proximité l'un de l'autre sous une étendue (4) de la plaque transparente constituant une zone sensible (6) d'une touche optique (7) destinée à être activée par la sous-face de l'extrémité d'un doigt (11), ledit détecteur étant relié à un circuit électronique d'acquisition suivi d'un circuit électronique de traitement.
